# EUROPÄISCHE PATENTSCHRIFT

(11) **EP 1 508 720 B1**
(45) Veröffentlichungstag und Bekanntmachung des Hinweises auf die Patenterteilung: **01.10.2008**
(21) Anmeldenummer: 04018547.2
(22) Anmeldetag: 05.08.2004
(51) Int. Cl.: F16F 1/02, H01L 41/053

(54) **Rohrfeder für Aktor**
Tubular spring for actuator
Ressort tubulaire pour actionneur

(30) Priorität: 19.08.2003 DE 10338080
(43) Veröffentlichungstag der Anmeldung: 23.02.2005
(73) Patentinhaber: ROBERT BOSCH GMBH, 70442 Stuttgart (DE)
(72) Erfinder: Stier, Hubert, 71665 Vaihingen/Enz (DE)
(74) Vertreter: Körfer, Thomas

(56) Entgegenhaltungen:
- WO-A-03/033933
- DE-A- 19 653 555
- DE-A- 19 951 012
- US-A1- 2003 034 594

## Beschreibung

### Stand der Technik

Die Erfindung geht aus von einer Rohrfeder für einen Aktor nach der Gattung des Hauptanspruchs.

Üblicherweise werden piezoelektrische oder magnetostriktive Aktoren zur Betätigung von Brennstoffeinspritzventilen für Brennstoffeinspritzanlagen von Brennkraftmaschinen zur Vermeidung von Zug- und Scherkräften durch eine Feder vorgespannt. Gewöhnlich wird zur Erzeugung der Vorspannung die auch bei geschlossenem Brennstoffeinspritzventil vorhandene Restspannung der Rückstellfeder des Brennstoffeinspritzventils genutzt.

Beispielsweise ist aus der DE 199 51 012 A1 ein Aktor, insbesondere zur Betätigung von Brennstoffeinspritzventilen für Brennstoffeinspritzanlagen von Brennkraftmaschinen, bekannt, welcher mehrere gestapelt angeordnete Schichten aus einem piezoelektrischen oder magnetostriktiven Material aufweist. Die Fixierung und Kraftübertragung erfolgt über eine Deckplatte und eine Bodenplatte.

Nachteilig an dieser Bauform ist dabei insbesondere die Notwendigkeit, die endseitigen Überständen umzubördeln, um eine axiale Kraftkomponent auf die Deckplatte und die Bodenplatte auszuüben.

In DE 196 53 555 A1 ist ein piezoelektrischer Aktor beschrieben, welcher piezoelektrische Elemente aufweist, die zumindest teilweise von Haltemitteln umgeben sind, die ein seitliches Knicken der piezoelektrischen Elemente verhindern. Zudem ist ein Federelement vorgesehen, das die piezoelektrischen Elemente in Form eines Piezo-Stapels zumindest teilweise umgibt. Der Piezo-Stapel ist von einem zylinderförmigen Faltenbalg umgeben. Der Faltenbalg wiederum ist von einer zylinderförmigen Distanzhülse umgeben. Der Piezo-Stapel weist auf dem der Kopfplatte gegenüberliegenden Ende einen Druckstempel auf, der mit dem zugeordneten Ende des Faltenbalges fest und umlaufend dicht verbunden ist. Weiterhin ist der Randbereich des Faltenbalges, der der Kopfplatte zugeordnet ist, mit der Distanzhülse umlaufend dicht verbunden. Durch diese Konfiguration wird ein Knicken der piezoelektrischen Elemente verhindert und eine kompakte und kurze Bauform erzielt.

US 2003/034594 A1 offenbart ein Federlager zum Vorspannen eines piezoelektrischen Aktors. Der Aktor, ein erster Kolben und ein zweiter Kolben sind hintereinander auf einer gemeinsamen Achse angeordnet und die Feder umgibt eine Druckkapsel, in welcher wiederum der erste und der zweite Kolben angeordnet sind. Dabei liegt eine am Randbereich der Feder vorgesehene radial nach innen gebogene Zentrierschulter an einem Einstellelement, welches zwischen dem Aktorfuß und dem ersten Kolben vorgesehen ist, an. Diese nach innen gebogene Zentrierschulter und eine weitere an dem gegenüberliegenden Randbereich der Feder vorgesehene radial nach außen gebogene Zentrierschulter dienen dazu, die Feder sowohl in dem Gehäuse des Einspritzventils als auch hinsichtlich der Druckkapsel auszurichten, wobei eine Kontaktoberfläche einer Schulter der Druckkapsel in Richtung des Federlagers und eine Kontaktoberfläche des Einstellelements auf dem ersten Kolben jeweils sphärische Krümmungen aufweisen, welche ein einfaches und effektives Zentrieren des Federlagers in Bezug auf die Druckkapsel und die zwei Kolben ermöglichen.

Vorteile der Erfindung

Die erfindungsgemäße Rohrfeder für einen Aktor mit den Merkmalen des Hauptanspruchs hat demgegenüber den Vorteil, dass bei der Verbindung zwischen Aktor und Rohrfeder zumindest eine Schweißnaht eingespart werden kann, wodurch der Herstellungsprozess günstiger und schneller wird. Außerdem erfolgt eine gleichmäßige Krafteinleitung in den Aktor, so dass während der Montage keine weiteren Verspannungen auftreten. Dies wird durch die Anbringung von Vorsprüngen an einem Ende der Rohrfeder erreicht.

Durch die in den Unteransprüchen aufgeführten Maßnahmen sind vorteilhafte Weiterbildungen und Verbesserungen der im Hauptanspruch angegebenen Rohrfeder möglich.

Vorteilhafterweise sind die Vorsprünge einstückig mit der Rohrfeder ausgebildet und beim Herstellungsprozess derselben mit dieser herstellbar.

Weiterhin ist von Vorteil, dass die Vorsprünge nach radial innen eingebogen sind und dadurch ein Widerlager für den Aktorkopf oder -fuß bilden.

Zudem ist vorteilhaft, dass die Federwirkung der Rohrfeder von den Vorsprüngen unbeeinflusst bleibt.

Die Rohrfeder kann weiterhin vorteilhafterweise in bekannter Weise ausgebildet sein und mit üblichen Aktoren zu einem Aktormodul verbunden werden.

### Zeichnung

Ausführungsbeispiele der Erfindung sind in der Zeichnung vereinfacht dargestellt und in der nachfolgenden Beschreibung näher erläutert. Es zeigen:
- Fig. 1: eine schematisierte Darstellung eines für die Bestückung mit einer erfindungsgemäßen Rohrfeder geeigneten Brennstoffeinspritzventils;
- Fig. 2A: eine Schnittdarstellung eines Ausführungsbeispiels einer erfindungsgemäß ausgestalteten Rohrfeder;
- Fig. 2B: eine schematische Aufsicht auf das abströmseitige Ende der erfindungsgemäß ausgestalteten Rohrfeder gemäß Fig. 2A;
- Fig. 3A: eine schematische Darstellung eines mit einer erfindungsgemäß ausgestalteten Rohrfeder versehenen Aktors; und
- Fig. 3B: eine schematische ausschnittsweise Darstellung einer weiteren Ausgestaltungsvariante eines mit einer erfindungsgemäß ausgestalteten Rohrfeder versehenen Aktors im Bereich IIIB in Fig. 3A.

### Beschreibung der Ausführungsbeispiele

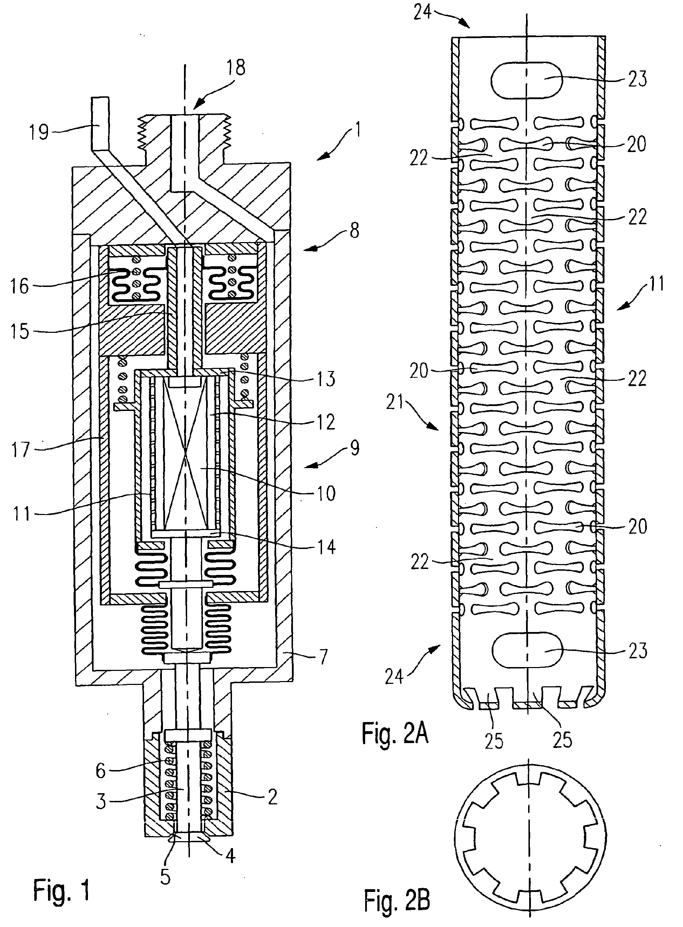

Fig. 1 zeigt zur besseren Verständlichkeit der Erfindung in einer stark schematisierten Darstellung ein zur Bestückung mit einer erfindungsgemäß ausgestalteten Rohrfeder geeignetes Brennstoffeinspritzventil.

Das in Fig. 1 dargestellte Brennstoffeinspritzventil 1 ist insbesondere als Brennstoffeinspritzventil 1 zum direkten Einspritzen von Brennstoff in einen nicht näher dargestellten Brennraum einer Brennkraftmaschine geeignet.

Das Brennstoffeinspritzventil 1 umfaßt einen Düsenkörper 2, in dem eine Ventilnadel 3 geführt ist. Diese weist an einem abströmseitigen Ende einen Ventilschließkörper 4 auf, welcher mit einer Ventilsitzfläche 5 einen Dichtsitz bildet. Das Brennstoffeinspritzventil 1 ist als nach außen öffnendes Brennstoffeinspritzventil 1 ausgebildet. Eine im Düsenkörper 2 angeordnete Rückstellfeder 6 beaufschlagt die Ventilnadel 3 so, daß das Brennstoffeinspritzventil 1 in der Ruhephase geschlossen gehalten bzw. die Ventilnadel 3 nach der Öffnungsphase in ihre Ruhestellung zurückgestellt wird.

Der Düsenkörper 2 mündet in ein Gehäuse 7 ein, in welchem ein hydraulischer Koppler 8 und ein Aktormodul 9 angeordnet sind.

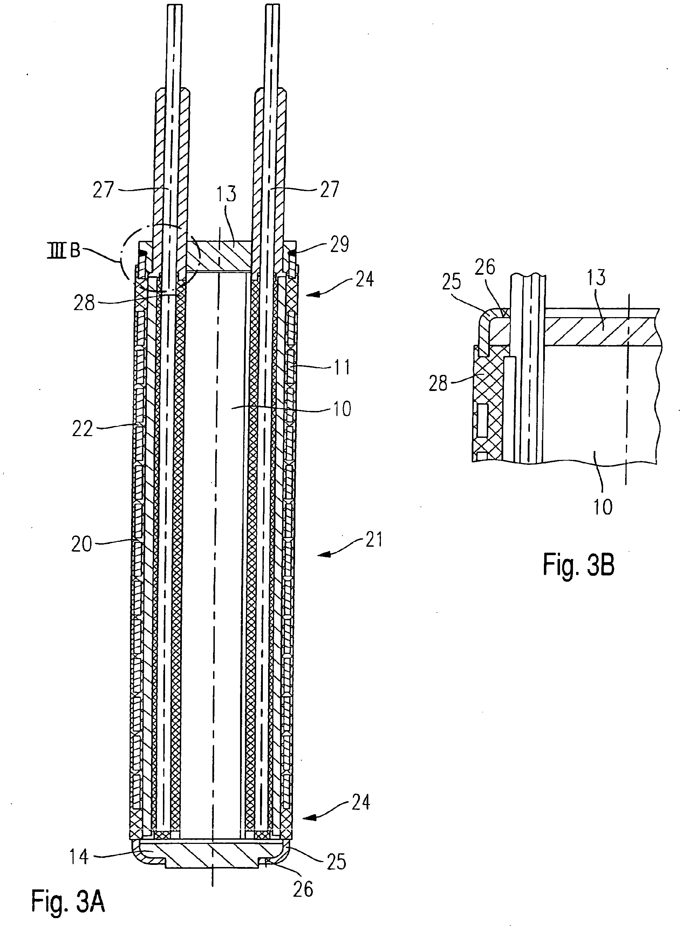

Das Aktormodul 9 umfaßt einen vorzugsweise piezoelektrischen Stapelaktor 10, welcher durch eine erfindungsgemäß ausgestaltete Rohrfeder 11 zum Schutz vor Scherkräften vorgespannt wird. Der Aktor 10 ist im vorliegenden Ausführungsbeispiel zusätzlich durch eine Umspritzung 12 geschützt. Der Aktor 10 weist einen Aktorfuß 13 und einen Aktorkopf 14 auf, welche mit der Rohrfeder 11 beispielsweise verschweißt sind. Die Rohrfeder 11 und die erfindungsgemäßen Maßnahmen werden weiter unten unter Bezugnahme auf die Fig. 2A, 2B, 3A und 3B näher beschrieben.

Der hydraulische Koppler 8, welcher zuströmseitig des Aktormoduls 9 angeordnet ist, umfaßt einen Arbeitskolben 15, welcher durch eine Kopplerfeder 16 gegenüber dem Gehäuse 7 vorgespannt ist. Der hydraulische Koppler 8 übersetzt den geringen Hub des piezoelektrischen Aktors 10 in einen größeren Hub der Ventilnadel 3.

Der Koppler 8 und das Aktormodul 9 sind in einem Aktorgehäuse 17 gekapselt. Dieses wird von dem zentral über einen Zulaufstutzen 18 zugeführten Brennstoff umströmt, welcher durch das Gehäuse 7 sowie durch den Düsenkörper 2 zum Dichtsitz strömt. Das Brennstoffeinspritzventil 1 ist über einen elektrischen Steckkontakt 19 betätigbar.

Um bei der Montage sowie beim Betrieb des Aktors 10 sicherzustellen, daß Scherkräfte, welche zur Zerstörung des Aktors 10 führen können, vermieden werden, ist der Aktor 10 in der Rohrfeder 11 gekapselt. Diese spannt den Aktor 10 vor, so daß dieser durch die auf ihn wirkenden ausschließlich axialen Kräfte stabilisiert wird.

Die herkömmlichen Rohrfedern 11 sind dabei, wie weiter oben erwähnt, mit dem Aktorkopf 14 und dem Aktorfuß 13 verschweißt, wobei der Aktor 10 dazwischen vorgespannt wird. Die Montage dieses Aktormoduls 9 ist aufwendig bedingt durch die mehrfache Schweißung. Zudem ist der Aktor 10 bei der Vormontage durch Scherkräfte gefährdet. Im Gegensatz dazu ist die erfindungsgemäß ausgestaltete Rohrfeder 11 für eine schonende und kostengünstige Montage geeignet.

Fig. 2A zeigt einen Längsschnitt durch eine erfindungsgemäß ausgestaltete Rohrfeder 11.

Die Rohrfeder 11 ist dabei hohlzylindrisch ausgebildet und kann beispielsweise aus einem Blech ausgestanzt, dann gebogen und an der Stoßkante verschweißt sein.

Bei der Herstellung der Rohrfeder 11 werden Ausnehmungen 20 in die Rohrfeder 11 eingebracht. Die Ausnehmungen 20 sind dabei regelmäßig über einen Teil der Fläche in einem mittleren Bereich 21 der Rohrfeder 11 verteilt, wobei die Ausnehmungen 20 annäherungsweise achtförmig ausgebildet sind. Die Ausnehmungen 20 sind durch Stanzen oder ähnliche Verfahren hergestellt. Zwischen den Ausnehmungen 20 bleiben durch den Bearbeitungsprozeß Stege 22 stehen, welche die stützende, aber federnde Wirkung der Rohrfeder 11 ausmachen. Durch die achtförmige Form der Ausnehmungen 20 ist die Rohrfeder 11 in ihrer axialen Ausdehnung flexibel. Sie kann leicht gezogen oder gestaucht werden. Die Federkonstante der Rohrfeder 11 wird dabei durch die Anzahl, Form, Größe und Anordnung der Ausnehmungen 20 beeinflußt.

Weiterhin sind Montageeingriffe 23 vorgesehen, welche für die Montage des Aktors 10 in der Rohrfeder 11 bzw. für die Einbringung einer Vorspannung benötigt werden. Die Montageeingriffe 23 sind in Endbereichen 24 der Rohrfeder 11 vorgesehen, welche abgesehen von den Montageeingriffen 23 eine geschlossene Fläche aufweisen. Sie sind zur gleichmäßigen Krafteinleitung zumindest paarig einander gegenüberliegend vorgesehen.

Erfindungsgemäß weist die Rohrfeder 11 an einem der Endbereiche 24 Vorsprünge 25 auf, welche einstückig mit der Rohrfeder 11 ausgebildet und nach radial innen eingebogen sind. Die Vorsprünge 25 sind zur formschlüssigen Verbindung der Rohrfeder 11 mit dem Aktorkopf 14 oder dem Aktorfuß 13 konzipiert, um zumindest einen Schweißprozeß bei der Montage des Aktors 10 in der Rohrfeder 11 einzusparen.

In Fig. 2B ist eine schematische Ansicht des Endbereichs 24 mit den Vorsprüngen 25 dargestellt.

Die Vorsprünge 25 sind, wie aus Fig. 2B ersichtlich, vorzugsweise rechteckig ausgebildet und etwa 3 mm breit, damit die Biegesteifigkeit beim Herstellungsprozeß nicht zu hoch ist. Sie können aber auch abgerundete Kanten für eine leichtere Montierbarkeit aufweisen. Die Anzahl der Vorsprünge 25 ist im Prinzip beliebig, sollte jedoch zur gleichmäßigen Krafteinleitung in den Aktor 10 mindestens vier betragen. In dem in Fig. 2B dargestellten Ausführungsbeispiel beträgt die Anzahl der Vorsprünge acht. Es können jedoch auch mehr oder weniger Vorsprünge 25 je nach der Form des in die Rohrfeder 11 einzusetzenden Aktorkopfes 14 oder Aktorfußes 13 vorgesehen sein.

Die Herstellung der Vorsprünge 25 erfolgt vorzugsweise durch Ausstanzen im gleichen Arbeitsschritt wie die Herstellung der Rohrfeder 11. Die Biegung der Vorsprünge 25 nach radial innen kann dabei auf zwei Arten erfolgen: entweder werden die Vorsprünge 25 nach dem Ausstanzen sofort gebogen, bevor die Rohrfeder 11 in ihre endgültige, rohrförmige Form gebracht wird, oder das Einbiegen erfolgt nach dem Rundbiegen der ausgestanzten Rohrfeder 11 und deren axialer Verschweißung.

Die axiale Federwirkung der Rohrfeder 11 wird durch die Vorsprünge 25 in keiner Weise negativ beeinflußt.

Fig. 3A zeigt ein Aktormodul 9, welches aus einem Aktor 10 und einer erfindungsgemäß ausgestalteten Rohrfeder 11 aufgebaut ist. Ein Aktorkopf 14 ist dabei in die Rohrfeder 11 eingelegt. Er stützt sich mit einer umlaufenden Schulter 26 an den Vorsprüngen 25 ab. Dadurch kann eine gleichmäßige Krafteinleitung auf den Aktor 10 gewährleistet werden. An dem Aktorkopf 14 liegt der Aktor 10 an. Die Krafteinleitung an der den Vorsprüngen 25 gegenüberliegenden Stirnseite des Aktors 10 erfolgt über einen Aktorfuß 13, welcher über eine Schweißnaht 29 mit der Rohrfeder 11 verbunden ist.

Bedingt durch den Formschluß der Vorsprünge 25 der Rohrfeder 11 mit dem Aktorfuß 14 kann eine der Schweißnähte, welche für die Montage eines herkömmlichen Aktormoduls 9 benötigt werden, entfallen, wodurch einerseits die Montage schneller und kostengünstiger wird und andererseits das Risiko verringert wird, daß der Aktor 10 während der Montage beschädigt wird.

Das Aktormodul 9 umfaßt weiter zwei Kontaktfahnen 27, welche der elektrischen Kontaktierung des Aktors 10 dienen und mittels einer Kunststoffumspritzung 28, welche gleichzeitig den Aktor 10 umgibt, an diesem fixiert sind.

In Fig. 3B ist in einer schematischen ausschnittsweisen Darstellung der in Fig. 3A mit IIIB bezeichnete Ausschnitt wiedergegeben, welcher eine weitere vorteilhafte Ausführungsform der erfindungsgemäß ausgestalteten Rohrfeder 11 darstellt. Hierbei sind die Vorsprünge 25 an derjenigen Seite des Aktors 10 angeordnet, an welcher sich auch die Kontaktfahnen 27 befinden. Der Formschluß zwischen der Rohrfeder 11 und dem Aktor 10 erfolgt somit nicht über den Aktorkopf 14, sondern über den Aktorfuß 13. Die beiden Ausführungsvarianten sind gleichwertig zueinander.

Die Erfindung ist nicht auf die dargestellten Ausführungsbeispiele beschränkt und insbesondere bei einer Vielzahl von Bauweisen von Brennstoffeinspritzventilen anwendbar. Auch sind alle Merkmale der Ausführungsbeispiele beliebig miteinander kombinierbar.

## Patentansprüche

1. Rohrfeder (11), welche zum Kapseln eines piezoelektrischen oder magnetostriktiven Aktor (5) mit einem Aktorfuss (13) und einem Aktorkopf (14) ausgebildet ist, welcher insbesondere zur Betätigung eines Brennstoffeinspritzventils (1) für Brennstoffeinspritzanlagen von Brennkraftmaschinen dient,
**dadurch gekennzeichnet,**
**dass** die Rohrfeder (11) an einem Endbereich (24) zumindest vier rechteckig ausgebildete Vorsprünge (25) aufweist, die eine Breite von 1 mm bis 5 mm aufweisen, und die radial nach innen eingebogen sind, wobei die zumindest vier Vorsprünge (25) zur formschlüssigen Verbindung der Rohrfeder (11) mit dem Aktorkopf (14) oder dem Aktorfuss (13) ausgebildet sind, wobei der Aktorkopf (13) oder der Aktorfuss (14) mit einer umlaufenden Schulter (26) an den zumindest vier Vorsprüngen (25) anliegt.

2. Rohrfeder nach Anspruch 1,
**dadurch gekennzeichnet,**
**dass** die Vorsprünge (25) eine Breite von ca. 3 mm aufweisen.

3. Rohrfeder nach einem der Ansprüche 1 bis 2,
**dadurch gekennzeichnet,**
**dass** die Rohrfeder (11) in einem mittleren Bereich (21) Ausnehmungen (20) und dazwischenliegende Stege (22) aufweist.

4. Rohrfeder nach einem der Ansprüche 1 bis 3,
**dadurch gekennzeichnet,**
**dass** an beiden Endbereichen (24) der Rohrfeder (11) Montageeingriffe (23) ausgebildet sind.

5. Rohrfeder nach einem der Ansprüche 1 bis 4,
**dadurch gekennzeichnet,**
**dass** der jeweils nicht in Formschluss mit den Vorsprüngen (25) der Rohrfeder (11) stehende Aktorfuss (14) oder Aktorkopf (13) mit der Rohrfeder über eine Schweißnaht (29) verbunden ist.

## Claims

1. Tubular spring (11) which is designed for encapsulating a piezoelectric or magnetostrictive actuator (5) having an actuator foot (13) and an actuator head (14), which actuator (5) serves in particular for actuating a fuel injection valve (1) for fuel injection systems of internal combustion engines,
**characterized**
**in that** the tubular spring (11) has, at one end region (24), at least four rectangular projections (25) which have a width of 1 mm to 5 mm and which are bent radially inward, with the at least four projections (25) being designed for a form-fitting connection of the tubular spring (11) to the actuator head (14) or to the actuator foot (13), with the actuator head (14) or the actuator foot (13) bearing with an encircling shoulder (26) against the at least four projections (25).

2. Tubular spring according to Claim 1,
**characterized**
**in that** the projections (25) have a width of approximately 3 mm.

3. Tubular spring according to one of Claims 1 to 2,
**characterized**
**in that** the tubular spring (11) has, in a central region (21), recesses (20) and interposed webs (22).

4. Tubular spring according to one of Claims 1 to 3,
**characterized**
**in that** assembly engagement recesses (23) are formed at both end regions (24) of the tubular spring (11).

5. Tubular spring according to one of Claims 1 to 4,
**characterized**
**in that** the actuator foot (13) or actuator head (14), whichever is not in form-fitting engagement with the projections (25) of the tubular spring (11), is connected to the tubular spring by means of a weld seam (29).

## Revendications

1. Ressort tubulaire (11) conçu pour encapsuler un actionneur piézoélectrique ou magnétostrictif (5) comportant un pied d'actionneur (14) et une tête d'actionneur (13), cet actionneur servant notamment à actionner un injecteur de carburant (1) dans des installations d'injection de carburant équipant des moteurs à combustions interne,
**caractérisé en ce que**
dans une zone d'extrémité (24) le ressort tubulaire (11) comporte, au moins quatre parties en saillie (25) de forme rectangulaire, ayant une largeur comprise entre 1 mm et 5 mm et recourbées radialement vers l'intérieur, au moins les quatre parties en saillie (25) étant réalisées pour assurer une liaison par la forme du ressort tubulaire (11) à la tête d'actionneur (13) ou au pied d'actionneur (14),
la tête d'actionneur (13) ou le pied d'actionneur (14) s'appliquant avec un épaulement périphérique (26) au moins contre les quatre parties en saillie (25).

2. Ressort tubulaire selon la revendication 1,
**caractérisé en ce que**
les parties en saillie (25) ont une largeur d'environ 3 mm.

3. Ressort tubulaire selon la revendication 1 ou 2,
**caractérisé en ce que**
dans une zone médiane (21) le ressort tubulaire (11) comporte des découpes (20) et des entretoises (22) dans l'intervalle.

4. Ressort tubulaire selon les revendications 1 à 3,
**caractérisé en ce que**
des découpes de montage (23) sont prévues dans les deux zones d'extrémité (24) du ressort tubulaire (11).

5. Ressort tubulaire selon les revendications 1 à 4,
**caractérisé en ce que**
le pied d'actionneur (14) ou la tête d'actionneur (13) qui ne sont pas respectivement en liaison de forme avec les parties en saillie (25) sont reliés au ressort tubulaire (11) par un cordon de soudure (29).
